# EUROPEAN PATENT APPLICATION

(11) **EP 0 886 326 A2**
(43) Date of publication of application: **23.12.1998**
(21) Application number: 98100853.5
(22) Date of filing: 19.01.1998
(51) Int. Cl.: H01L 33/00

(54) **Separate hole injection structure for improved reliability light emitting semiconductor devices**

(30) Priority: 06.06.1997 US 870570
(71) Applicant: Hewlett-Packard Company, Palo Alto, California 94304 (US)
(72) Inventor: Stockman, Stephen A., Morgan Hill, CA 95037 (US)
(74) Representative: Schoppe, Fritz, Dipl.-Ing.

(57) **Abstract**

The recombination-enhanced degradation of the p-type heterointerface active layer or confining layer, of a double heterostructure (DH) light-emitting semiconductor device can be minimized by using hole injection into an n-type DH from a remote p-type hole injection layer. The hole injection layer is designed to achieve an acceptable hole injection efficiency and minimize optical absorption. The doping level and the species are selected to accurately control the p-n junction position.

## Description

### FIELD OF THE INVENTION

The invention is directed towards the field of light emitting semiconductor diodes. In particular, the invention applies to the improving the reliability of such devices.

### BACKGROUND OF THE INVENTION

Highly efficient visible light-emitting diodes (LEDs) have been produced in the red, orange, yellow, and green spectral regions by employing the AlₓGa₁₋ₓAs and (AlₓGa₁₋ₓ)_{y}In_{1-y}P material systems and double heterostructure (DH) devices that use a "bulk" active region in the thickness range of 0.1 to 5.0 µm. These highly efficient LEDs typically use a direct band-to-band transition to produce the light of an appropriate wavelength. The DH-structure confines the minority carrier (typically electrons) to the active region. The basic DH-structure consists of an n-type confining layer (with a electron concentration of n_{CL}), active layer for generating light via radiative electron-hole recombination, and a p-type confining layer (with a hole concentration of p_{CL}). The p-n junction is placed within the active layer or at either one of the active/confining layer interfaces. Typically, the p-n junction position is chosen to optimize the injection efficiency. This basic structure may often be modified for different reasons. For example, to accommodate quantum wells within the active region, or to optimize optical confinement in the case of semiconductor lasers. This basic DH structure is employed in many commercially available devices such as LEDs and laser diodes based on the InP/InGaAsP, GaAs/AlGaAs, and GaAs/AlGaInP material systems, as well as GaN/AlGaInN LEDs. In addition, short-wavelength GaN and II-VI semiconductor lasers employing a DH design have been demonstrated.

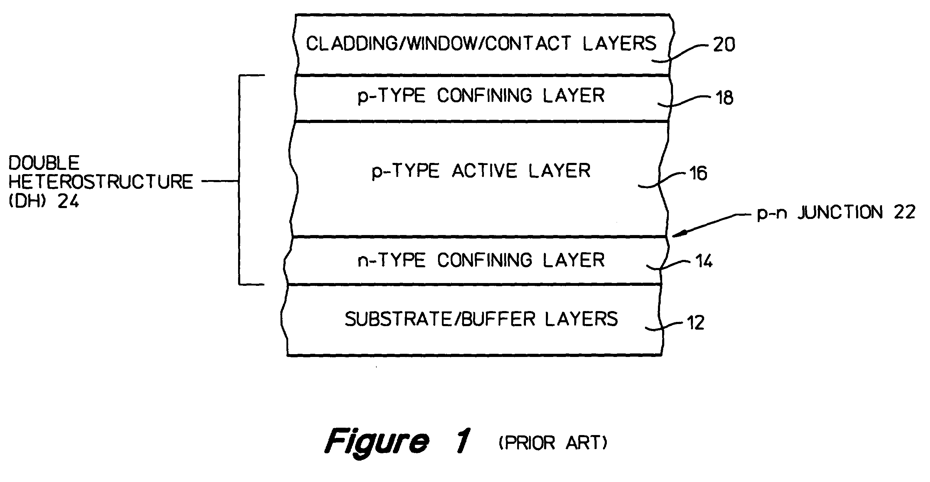

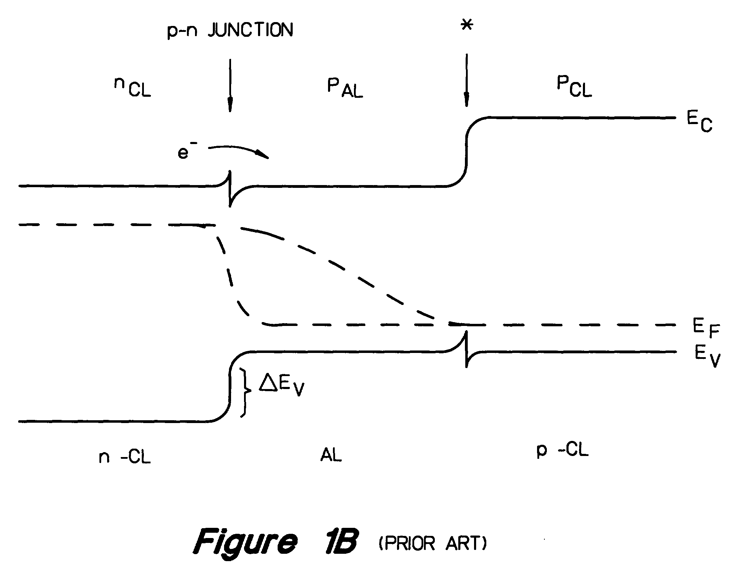

A schematic diagram for a typical DH LED layer structure is shown in Figure 1A, with a corresponding band diagram in Figure 1B. In this case, an n-type confining layer is positioned over the substrate, followed by a p-type active layer (with a hole concentration of p_{AL}) and a p-type confining layer (shown in Figure 1A). A p-n junction is controllably positioned at the confining layer / active layer interface. Final device layers are built upon the p-type confining layer. Efficient minority carrier (electron) injection into the active layer is achieved by using a high n_{CL}/p_{AL} doping ratio and a large valence band offset ΔE_{V}. For AlGaInP LEDs, the confining layers (CLs) are (AlₓGa₁₋ₓ)_{.5}In_{.5}P (0.5 ≤ x ≤ 1) and the active layer (AL) is (AlₓGa₁₋ₓ)_{.5}In_{.5}P (0 ≤ x ≤ 0.5). The epitaxial structure may be grown "p-side up" on an n-type substrate as shown in Figure 1, or "p-side down" on a p-type substrate.

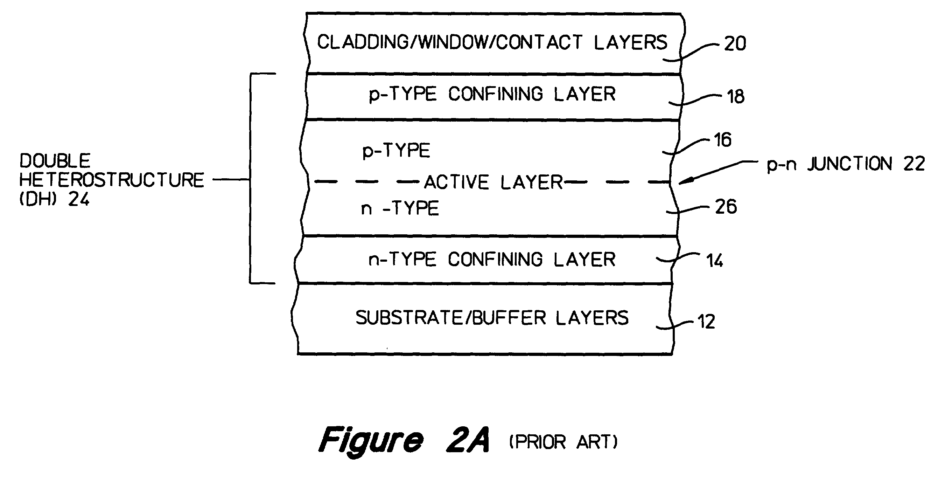

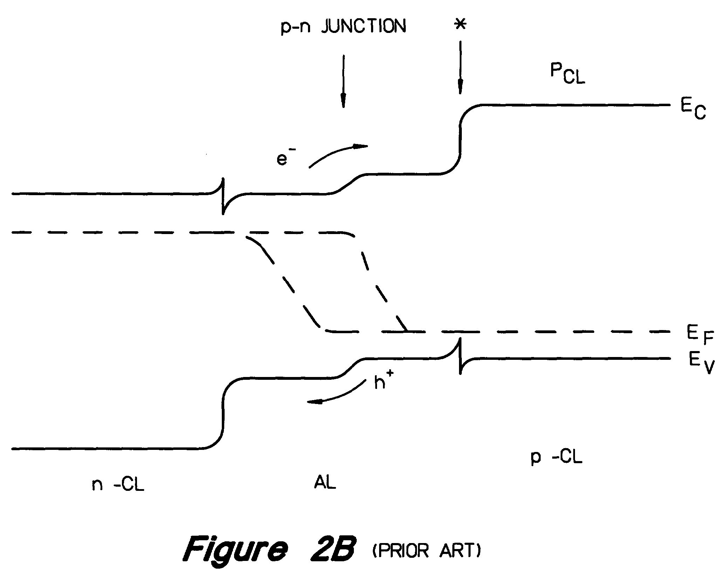

Another version of the conventional DH LED structure is shown in Figures 2A and 2B. In this device, the p-n junction is located within the active layer. Efficient electron injection into the p-type side of the AL may not be as critical as for the device in Figure 1A, since holes injected into the n-type side of the AL may also contribute to light emission. Conventional DH LEDs are designed with the p-n junction placed somewhere in the active layer as shown in Figures 1A or 2A to optimize carrier injection and confinement and to maximize the LED efficiency. The devices of Figures 1A and 2A share the common characteristic that all or part of the active layer, one of the confining layers, and the heterointerface where they join are p-type. This basic structure is also employed for compound semiconductor laser diodes and other light-emitting devices such as optical amplifiers.

### SUMMARY OF THE INVENTION

The present invention reduces or eliminates the recombination-enhanced degradation of the p-type heterointerface or p-type active layer or confining layer in light-emitting semiconductor devices by using hole injection into an n-type double heterostructure from a remote p-type hole injection layer. The hole injection layer should have the desirable characteristics of high p-type doping, and a large bandgap E_{g} or conduction band offset ΔE_{c} relative to the DH layers, in order to achieve a acceptable injection efficiency and minimize optical absorption. The doping level and the dopant species are selected to accurately control the p-n junction position.

### BRIEF DESCRIPTION OF THE DRAWINGS

Figures 1A and 1B illustrate a layer structure and corresponding band diagram of a DH light emitting diode with a p-type active layer (prior art).

Figures 2A and 2B illustrate a layer structure and corresponding band diagram for a DH light emitting diode with the p-n junction in the active layer (prior art).

Figures 3A and 3B illustrate a embodiment of the present invention and a corresponding band diagram.

Figures 4A and 4B illustrate an alternate embodiment of the present invention and a corresponding band diagram.

### DETAILED DESCRIPTION OF THE DRAWINGS

We have identified a new and very important degradation mode in high efficiency AlGaInP LEDs. This is the recombination-enhanced degradation of p-type semiconductor confinement layers and heterointerfaces in the DH structure. When this occurs, the efficiency of the LED can decrease significantly during device operation, resulting in poor reliability. The time required for significant degradation to occur may vary from less than 1 minute to several thousand hours depending on the LED operating conditions, including drive current and junction temperature. This degradation mode is most prevalent when the LEDs are operated at high current densities (> 20 A/cm²), but has also been observed at low current densities. In some cases, the current-voltage characteristics may also change during device operation.

Minimizing the effect of this degradation mode would result in devices maintaining efficiency during operation and improved reliability. In fact, finding a solution this problem is essential to ensure penetration of high brightness LEDs into applications such as exterior automotive lighting, traffic signals, outdoor signs and illumination, and fiber-optic communication, where long-term reliability is of paramount importance.

We have discovered that this degradation mode occurs only in p-type layers, and is often concentrated in the region near an interface between two p-type semiconductor layers of different compositions. This mode of degradation may occur in other wide-gap (visible and UV emitting) materials systems and may be important in narrow-gap (IR-emitting) materials systems as well. The present invention solves this problem by using a separate hole-injection layer in close proximity to a DH structure which is completely n-type. This structure should provide improved reliability since the electron-hole recombination will not occur at or near any critical p-type interfaces. Although the inventive concept focuses on the application of separate hole-injection structures for LEDs, the concept is extendible to any light emitting semiconductor device.

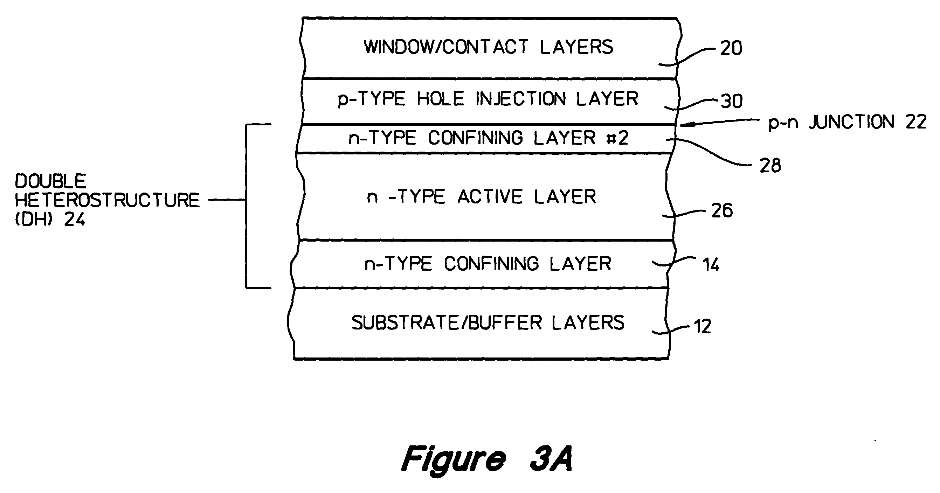

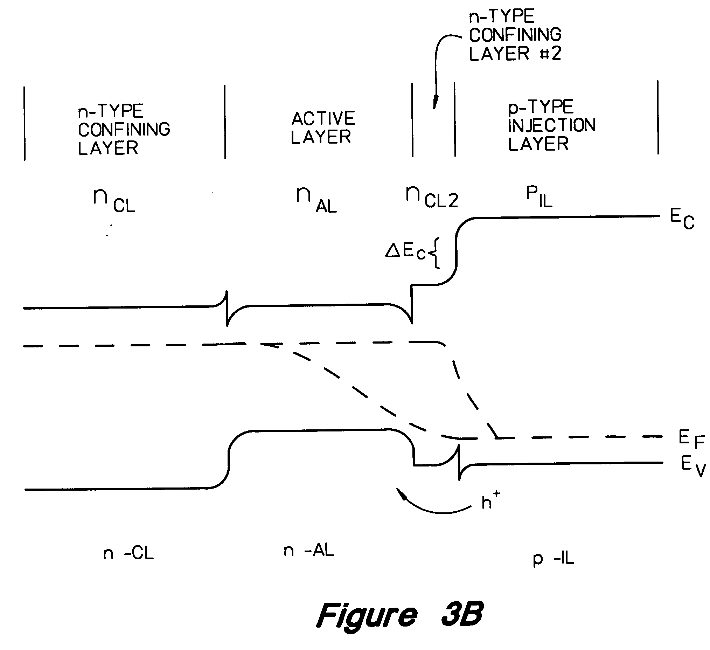

Figure 3A illustrates the present invention, with a corresponding band diagram shown in Figure 3B. Recombination-enhanced degradation may be minimized by replacing the p-type confining layer 18 shown in Figure 2A with a second n-type confining layer 28 and a p-type hole-injection layer 30 as shown in Figure 3. Holes are injected into the n-type DH 24 from the remote p-type hole injection layer 30, and recombine with electrons in the n-type AL 26 to produce photons.

In this embodiment, the active layer 26 and DH structure 24 interfaces (the intersection of the AL 26 and confining layer 14, and the intersection of the AL 26 ad confining layer 28) are n-type and efficient minority carrier (hole) injection is achieved by using a high p_{IL}/n_{CL} doping ratio and/or ΔE_{g} or conduction band offset ΔE_{c}. The hole concentration in the injection layer 30 is defined as p_{IL}. The electron concentration in the confining layer 28 is defined as n_{CL}. The bandgap energy is E_{g} while ΔE_{g} is defined as E_{g} (injection layer 30) - E_{g} (second confining layer 28). The conduction band energy when referenced to the vacuum level is E_{c} while ΔE_{c} is defined as E_{c} (injection layer 30) - E_{c} (second confining layer 28). The second n-type confining layer 28 should be kept thin, within a thickness t_{CL2} of 0 < t_{CL2} ≤ Lₚ, where Lₚ is the hole diffusion length in the n-type confining layer (typically ∼ 1 µm). The desirable characteristics for the hole injection layer 30 are a large E_{g} or ΔE_{c}, a high doping level p_{IL} ≥ 1 x 10¹⁷ cm⁻³, and a low p-dopant diffusivity so that the p-n junction position may be accurately controlled. The injection layer 30 should if possible be optically non-absorbing. In the preferred embodiment, the injection layer 30 is C-doped AlGaAs, GaP, AlGaP, GaAsP, AlGaAsP, AlInP, or AlGaInP. Carbon is advantageous as a p-dopant because it has a very low diffusivity and high doping levels (10¹⁸ < p < 10²¹ cm⁻³) have been demonstrated. The reliability of the DH device of Figure 3A is greatly improved as there are no p-type interfaces which are susceptible to recombination-enhanced degradation.

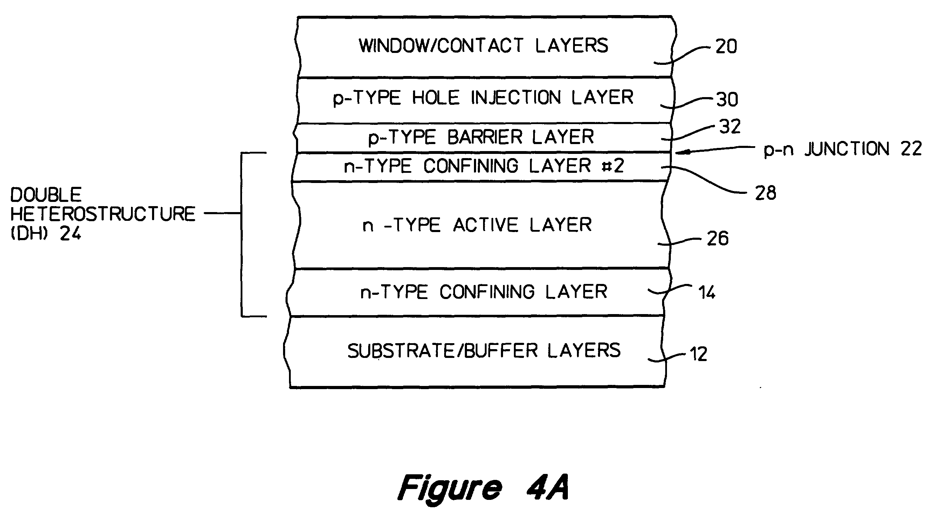

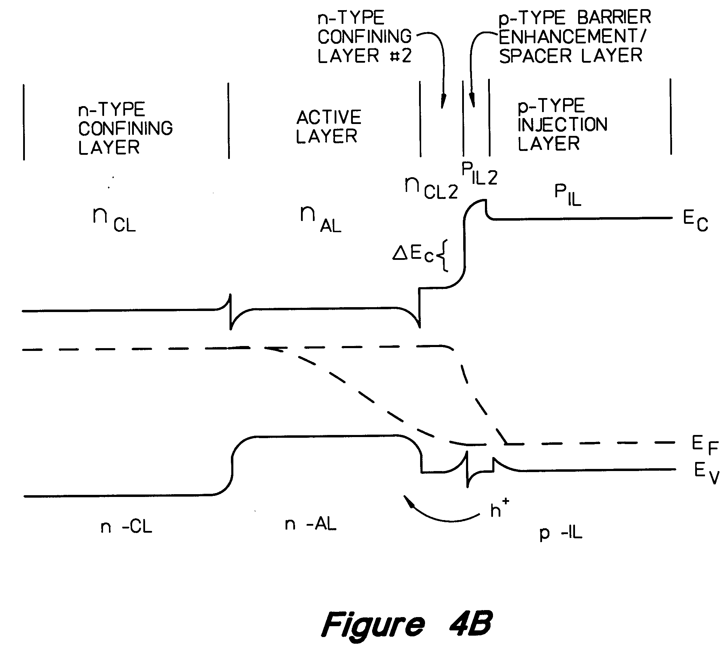

Figure 4A illustrates an alternate embodiment of the present invention and a corresponding band diagram is shown in Figure 4B. An p-type barrier layer 32 is inserted between the second n-type confining layer 28 and the p-type injection layer 30 to create a larger effective barrier. This p-type barrier layer 32 may reduce electron reverse-injection into the injection layer or accommodate dopant redistribution which might occur during epitaxial growth, thermal processing, or device operation. The layer can be lattice-matched or mismatched (strained or relaxed), although the layer should be made as defect-free as possible.

A variety of factors including undesirable band offsets, doping limitations, or other incompatibilities may limit the choices which are practical for making the devices shown in Figures 3A and 4A. In these situations, minor modifications may be made to achieve the desired result. For example, the interface between the active layer and the second n-type confining layer may be in the depletion region of the p-n junction if necessary to achieve optimal hole injection efficiency. In addition, the structure may be grown p-side up (as shown in Figures 3A and 4A) or p-side down (inverted) without changing its function.

In Figures 3A and 4A, the n-type AL 26 is a single epitaxial layer. This design may be modified for a number of reasons, and may consist of multiple n-type layers. For example, a quantum-well or multiple-quantum-well structure is typically used in edge-emitting and vertical-cavity laser diodes. In addition, the heterointerfaces may be compositionally graded or abrupt. Thus, the active layer in Figures 3 and 4 may be replaced by a active region, which may be comprised of any number of n-type layers.

This approach may be applied to a number of different materials and devices. These include, but are not limited to, visible light emitters such as AlGaAs and AlGaInP-based LEDs and laser diodes and GaN-based and ZnSe-based blue LEDs and lasers. The teachings of this invention may be used for any light-emitting III-V or II-VI semiconductor device having a DH-based structure for carrier confinement, including LEDs, laser diodes, and optical amplifiers.

The preferred embodiment of the present invention may be manufactured by growing an n-type double heterostructure on a substrate. A p-type hole-injection layer is fabricated over the double heterostructure. The p-type hole-injection layer may be initially grown as an undoped hole-injection layer and subsequently doped either by diffusion during growth or by post-epitaxial growth processing, such as diffusion or ion implantation. Alternatively, the p-type hole-injection layer may be attached to the double heterostructure via wafer bending or epitaxial regrowth. The optional p-type barrier enhancement layer may be fabricated in a manner similar to the p-type hole-injection layer. The additional device layers such as a window and/or a contact layer are grown over the p-type hole-injection layer. The epitaxial growth technique used may be MOCVD, MBE, LPE, VPE, or any combination thereof.

As described in the text above, there are a number of other possible embodiments that require extending or changing the aforementioned manufacturing process. For example, if the device is fabricated on a p-type substrate, the hole-injection layer may be grown on the substrate and the n-type double heterostructure may be subsequently grown.

## Claims

1. A light-emitting semiconductor device comprising:
a substrate (12);
a double heterostructure (24) positioned over the substrate that includes,
a first and a second n-type confining layer (14,28), and
an n-type active region (26), containing at least one layer, interposing the first and the second confining layers; and
a p-type hole-injection layer (30), positioned proximate to the second confining layer.

2. A light-emitting semiconductor device, as defined in claim 1, further comprising:
a barrier enhancement/spacer layer (32) of p-type that interposes the second n-type confining layer and the p-type hole-injection layer.

3. A light-emitting semiconductor device, as defined in claim 1, wherein the second confining layer (28) has a thickness of less than 1 µm.

4. A light-emitting semiconductor device, as defined in claim 1, wherein the p-type hole-injection layer (30) is lattice-mismatched with respect to the substrate, confining layers, and active region.

5. A light-emitting semiconductor device, as defined in claim 1, wherein:
the n-type double heterostructure (24) is a compound of AlₓGa_{y}In_{1-x-y}P (0≤x, y≤1); and
the p-type hole injection layer (30) is selected from a group that includes AlₓGa_{y}In_{1-x-y}P(0≤x,y≤1), AlₓGa_{y}In_{1-x-y}As_{z}P_{1-z} (0≤x,y,z≤1), AlₓGa₁₋ₓAs_{y}P_{1-y} (0≤x,y≤1) AlₓGa₁₋ₓP(0≤x≤1), and AlₓGa₁₋ₓAs(0≤x≤1).

6. A light-emitting semiconductor device, as defined in claim 5, wherein the p-type dopant is selected from a group that includes carbon, magnesium, zinc, cadmium, and beryllium.

7. A light-emitting semiconductor device, as defined in claim 6, the hole injection layer (30) further comprising a doping level of at least 1 x 10¹⁷.

8. A light-emitting semiconductor device, as defined in claim 2, wherein the p-type barrier enhancement/spacer layer (32) is lattice-mismatched with respect to the substrate, confining layers, active region, and hole-injection layer, and is pseudomorphically-strained or lattice-relaxed.

9. A light-emitting semiconductor device, as defined in claim 2, wherein the p-type barrier enhancement layer (32) has multiple p-type sublayers.

10. A light-emitting semiconductor device, as defined in claim 2, wherein:
the n-type double heterostructure (24) is a compound of AlₓGa_{y}In_{1-x-y}P (0≤x,y≤1); and
the p-type barrier enhancement/spacer layer (32) is selected from a group that includes AlₓGa_{y}In_{1-x-y}P(0≤x,y≤1), AlₓGa_{y}In_{1-x-y}As_{z}P_{1-z} (0≤x,y,x≤1), AlₓGa₁₋ₓAs_{y}P_{1-y} (0≤x,y≤1), AlₓGa₁₋ₓP(0≤x≤1), and AlₓGa₁₋ₓAs(0≤x≤1).

11. A method for fabricating a light-emitting semiconductor device comprising the steps of:
growing an n-type double heterostructure on a substrate;
fabricating a p-type hole-injection layer over the double heterostructure; and
growing a window layer/contact layer over the p-type hole-injection layer.

12. A method for fabricating a light-emitting semiconductor device, as defined in claim 11, the step of fabricating a p-type hole-injection layer further comprising the steps of:
growing an undoped hole-injection layer; and
doping the hole-injection layer with a p-type dopant.

13. A method for fabricating a light emitting semiconductor device, as defined in claim 12, the step of doping the hole injection layer comprising the step of diffusing the p-type dopant into the hole-injection layer.

14. A method for fabricating a light emitting semiconductor device, as defined in claim 12, the step of doping the hole injection layer comprising the step of implantation of p-type dopant into the hole-injection layer.

15. A method for fabricating a light emitting semiconductor device, as defined in claim 11, the step of fabricating a p-type hole-injection layer comprising the step of wafer bonding the p-type hole injection layer onto the double heterostructure.

16. A method for fabricating a light emitting semiconductor device, as defined in claim 11, the step of fabricating a p-type hole-injection layer comprising the step of epitaxially regrowth of the p-type hole injection layer over the double heterostructure.

17. A method for fabricating a light emitting semiconductor device, as defined in claim 11, further comprising the step of fabricating a p-type barrier enhancement/spacer layer prior to the step of fabricating a p-type hole-injection layer.

18. A method for fabricating a light-emitting semiconductor device, as defined in claim 17, the step of fabricating a p-type barrier enhancement/spacer layer further comprising the steps of:
growing an un-doped barrier enhancement/spacer layer; and
doping the barrier enhancement/spacer layer with a p-type dopant.

19. A method for fabricating a light emitting semiconductor device, as defined in claim 18, the step of doping the barrier enhancement/spacer layer comprising the step of diffusing the p-type dopant into the barrier enhancement/spacer layer.

20. A method for fabricating a light emitting semiconductor device, as defined in claim 18, the step of doping the barrier enhancement/spacer layer comprising the step of implanting the p-type dopant into the barrier enhancement/spacer layer.
